# EUROPEAN PATENT APPLICATION

(11) **EP 4 693 409 A1**
(43) Date of publication of application: **11.02.2026**
(21) Application number: 24781291.0
(22) Date of filing: 29.03.2024
(51) Int. Cl.: H01L 29/778, H01L 29/20, H01L 29/08

(54) **HIGH ELECTRON MOBILITY TRANSISTOR AND DRIVING DEVICE THEREOF**

(30) Priority: 29.03.2023 US 202363492809 P
(71) Applicant: Lucid Microsystems Co., Ltd., Suwon-si, Gyeonggi-do 16512 (KR)
(72) Inventor: GAO, Zihao Mike, Gilbert,, Arizona 85295 (US); REN, Xiaowei, Plano, Texas 75093 (US); LEE, Ki Sun, Pleasanton, California 94566 (US); SONG, Kyung Hoon, Suwon-si Gyeonggi-do 16505 (KR); LEE, Young Min, Seoul 05698 (KR); EOM, Han Yong, Sunnyvale, California 94087 (US)
(74) Representative: Puschmann Borchert Kaiser Klettner Patentanwälte Partnerschaft mbB
(86) International application number: PCT/KR2024/004026
(87) International publication number: WO 2024/205301

(57) **Abstract**

An embodiment relates to a high electron mobility transistor (HEMT) and provides the HEMT including: a first drain terminal; a gate terminal; a second drain terminal; a channel layer having a first drift area formed between the first drain terminal and the gate terminal; a channel area formed at a location corresponding to the gate terminal; and a second drift area formed between the second drain terminal and the gate terminal; and a ground plate interposed between the gate terminal and the second drain terminal.

## Description

### Technical Field

The present embodiment relates to a high electron mobility transistor and a technology for driving the same.

### Background Art

Devices using power, such as battery chargers, DC-DC converters, AC-DC inverters, motor controllers, and LED lighting devices, require power devices with low on-resistance (Ron) and high breakdown voltage (BV) to improve overall power efficiency. However, according to the well-known scaling law for silicon-based power devices, Ron is proportional to BV to the power of 2.5. This means that achieving low Ron while maintaining a high BV is practically impossible because a high BV further increases Ron.

Ron is composed of multiple resistive components within a power transistor, and among the resistive components, drift resistance of a drift area is a major contributor, increasing linearly with length. Longer drift lengths are typically used to improve BV, but this is to prevent a rapid increase in the critical electric breakdown field due to a short resistance path. This naturally leads to a tradeoff: higher on-resistance due to a longer drift length.

To overcome these limitations, wide-bandgap (WBG) semiconductors, such as gallium nitride (GaN) and silicon carbide (SiC), are widely used in power applications. The WBG semiconductors have a wide energy bandgap, similar to the high critical electric breakdown field, and the critical electric breakdown field is proportional to the square of the energy bandgap. WBG transistors can significantly shorten the drift length without premature BV avalanche, resulting in reduced on-resistance.

In a low- and medium-voltage range (≤650 V), GaN high electron mobility transistors (HEMTs) are commonly chosen due to their nearly perfect balance between voltage, current, and on-resistance. Like silicon power transistors, the on-resistance of GaN HEMTs scales linearly with breakdown voltage (BV), but the relationship between Ron and BV is weaker.

Unlike silicon transistors, GaN HEMTs lack a body diode, and thus can operate bidirectionally using the D1 and D2 terminals. This unique feature allows GaN HEMTs to provide two distinct functions in each direction. In one direction, a device with the D1 terminal functions as a voltage-blocking device, while in the other direction, a device with the D2 terminal functions as a general switching device.

Since the on-resistance of a GaN HEMT is the sum of the drift resistance and the channel resistance, the drift length on both D1 and D2 must be kept as short as possible to reduce the overall Ron and maximize power efficiency. On the switching side, D2, drift length adjustment is limited by several performance issues, such as hot carrier injection (HCI) and internal capacitance. However, on the blocking side, D1, the simple blocking function allows for minimal drift length, depending on the photolithography capabilities of the manufacturer. The drift length is defined by the blocking voltage requirement, and can be designed with twice the voltage on the switching side to meet the blocking function.

As is known, the breakdown voltage (BV) of the GaN HEMT is proportional to the drift length. Therefore, the drift length of D1 should be sufficiently long to support the required blocking voltage, but at the same time, it can be twice as large as that of D2 side. Since the Ron of bidirectional GaN (bi-GaN) is the sum of Ron of D1 and Ron of D2, the large Ron added to support the blocking function on the D1 side can severely degrade the switching performance on the D2 side. A longer D1 drift length can further degrade the switching performance by increasing the parasitic capacitance of the D1 drain and the capacitance included in the overall metal routing.

### DETAILED DESCRIPTION OF THE INVENTION

### Technical Problem

In this background, an object of the present embodiment is to provide a technique for achieving optimal power efficiency with low Ron while overcoming the limitations of short drift lengths that make it difficult to support BV in an aspect. In another aspect, an object of the present embodiment is to provide a novel technique for improving the performance of a bi-GaN device without sacrificing BV characteristics and reducing parasitic capacitance in the D1 drain and metal routing.

### Technical Solution

To achieve the aforementioned objects, an embodiment provides a high electron mobility transistor (HEMT) including a first drain terminal, a gate terminal, a second drain terminal, a channel layer in which a first drift area is formed between the first drain terminal and the gate terminal, a channel area is formed at a location corresponding to the gate terminal, and a second drift area is formed between the second drain terminal and the gate terminal, and a ground plate disposed between the gate terminal and the second drain terminal.

The first drain terminal, the gate terminal, and a region corresponding to a position from the first drain terminal to the gate terminal in the channel layer may form a first element, the second drain terminal, the gate terminal, and a region corresponding to a position from the second drain terminal to the gate terminal in the channel layer may form a second element, the first element may operate as a voltage blocking element, and the second element may operate as a switching element.

A length of the ground plate in a direction from the second drain terminal to the gate terminal may be a minimum length of a predetermined design rule (DR).

The HEMT may be of a horizontal type, the channel layer may be disposed below the first drain terminal, the gate terminal, and the second drain terminal in a vertical direction, the first drain terminal, the gate terminal, and the second drain terminal may be disposed in that order in a horizontal direction, and the ground plate may be disposed between the gate terminal and the second drain terminal in the horizontal direction.

A portion of the second drift area may be formed below the ground plate.

An insulating layer may be disposed between the ground plate and the channel layer.

At least one of a buffer layer and a substrate layer may be disposed under the channel layer.

The ground plate may be disposed between the gate terminal and the second drain terminal and may not be disposed between the gate terminal and the first drain terminal.

A length between the first drain terminal and the gate terminal on the upper surface of the channel layer may be equal to a minimum allowable length of a predetermined photolithography process.

The channel layer may include a 2DEG formed at an interface of adjacent AlGaN/GaN structures.

Another aspect provides a device for driving a HEMT including a channel layer in which a first drift area is formed between a first drain terminal and a gate terminal, a channel area is formed at a location corresponding to the gate terminal, and a second drift area is formed between a second drain terminal and the gate terminal, the device including a gate driver configured to supply a voltage lower than a voltage of the second drain terminal to the gate terminal when turning off the HEMT.

The first drain terminal, the gate terminal, and a region corresponding to a position from the first drain terminal to the gate terminal in the channel layer may form a first element, and the second drain terminal, the gate terminal, a region corresponding to a position from the second drain terminal to the gate terminal in the channel layer may form a second element, the first element may operate as a voltage blocking element, and the second element may operate as a switching element.

The HEMT may further include a ground plate disposed between the gate terminal and the second drain terminal.

A length between the first drain terminal and the gate terminal on the upper surface of the channel layer may be equal to a predetermined minimum allowable length of a photolithography process.

A length of the ground plate may be a minimum length of a predetermined design rule (DR) in a direction from the second drain terminal to the gate terminal.

Another embodiment provides a high electron mobility transistor (HEMT) including a first drain terminal, a gate terminal, a second drain terminal; and a channel layer in which a first drift area is formed between the first drain terminal and the gate terminal, a channel area is formed at a location corresponding to the gate terminal, and a second drift area is formed between the second drain terminal and the gate terminal, wherein a negative bias is applied as a gate voltage between the gate terminal and the second drain terminal when the HEMT is turned off.

The HEMT may further include a ground plate disposed between the gate terminal and the second drain terminal.

A length of the ground plate may be a minimum length of a predetermined design rule (DR) in a direction from the second drain terminal to the gate terminal.

The HEMT may be an enhancement-mode (E-mode) HEMT exhibiting a normally-off state.

A length between the first drain terminal and the gate terminal on the upper surface of the channel layer may be equal to a minimum allowable length of a predetermined photolithography process.

### Effects of the Invention

As described above, the present embodiment can achieve optimal power efficiency with low Ron while overcoming the limitations of short drift lengths that make it difficult to support BV in power devices. Furthermore, the present embodiment can improve bi-GaN device performance without sacrificing BV characteristics and reduce parasitic capacitance in the D1 drain and metal routing.

### BRIEF DESCRIPTION OF THE DRAWINGS

FIG. 1 is a cross-sectional view of a HEMT according to an embodiment.
FIG. 2 is a cross-sectional view of a GaN HEMT according to an embodiment, in which terminals and a channel layer are shown in an enlarged view.
FIG. 3 is a diagram illustrating the configuration of a switching device according to an embodiment.
FIG. 4 is a diagram illustrating the configuration of a voltage blocking device according to an embodiment.
FIG. 5 is a circuit model of a GaN HEMT according to an embodiment.
FIG. 6 is a graph showing the breakdown voltage of a GaN HEMT according to the gate voltage on a linear scale.
FIG. 7 is a graph showing the breakdown voltage of a GaN HEMT according to the gate voltage on a logarithmic scale.
FIG. 8 is a diagram showing the configuration of a GaN HEMT driving device according to an embodiment.

### Mode for Implementing the Invention

Hereinafter, some embodiments of the present disclosure will be described in detail with reference to the accompanying drawings. With regard to the reference numerals of the components of the respective drawings, it should be noted that the same reference numerals are assigned to the same components even though they are shown in different drawings. In addition, in describing the present disclosure, a detailed description of a well-known configuration or function related to the present disclosure, which may obscure the subject matter of the present disclosure, will be omitted.

In addition, terms, such as "first", "second", "A", "B", "(a)", and "(b)", may be used in describing the components of the present disclosure. These terms are intended only for distinguishing a corresponding component from other components, and the nature, order, or sequence of the corresponding component is not limited to the terms. In the case where a component is described as being "coupled", "combined", or "connected" to another component, it should be understood that the corresponding component may be directly coupled or connected to another component or that the corresponding component may also be "coupled", "combined", or "connected" to the component via another component provided therebetween.

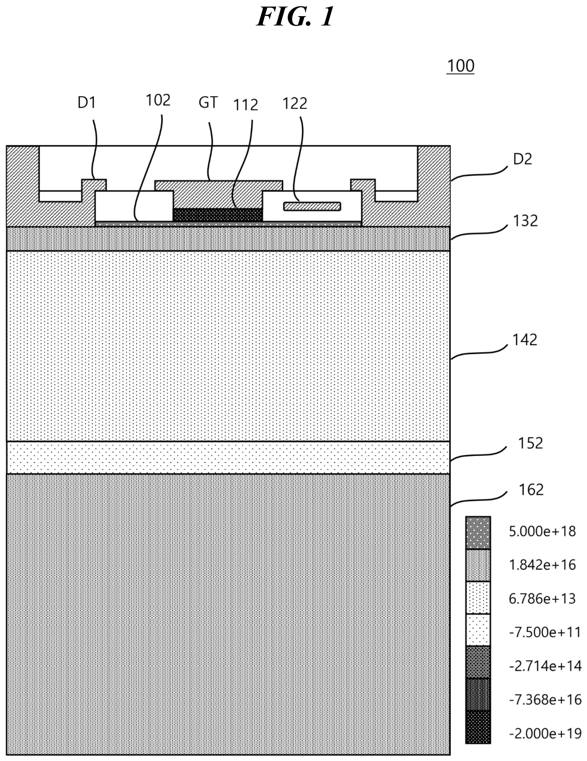

FIG. 1 is a cross-sectional view of a HEMT according to an embodiment.

Referring to FIG. 1, a high electron mobility transistor (HEMT) may include a first drain terminal D1, a gate terminal GT, and a second drain terminal D2. For convenience of description, the side where the terminals D1, GT, and D2 are located is referred to as an upper side, and the side where a substrate layer 162 is formed is referred to as a lower side.

The HEMT 100 is a semiconductor device having high electron mobility and is known to have excellent performance in high-speed switching and high-frequency regions. The HEMT 100 is based on a two-dimensional electron gas (2DEG). At the interface between a barrier layer 102 and a channel layer 132 of the HEMT 100, spontaneous polarization and deformation polarization combine to form a strong electric field. This phenomenon can induce abundant electrons into the channel layer 132, forming a two-dimensional electron gas (2DEG).

The electrons in the 2DEG have very low effective masses and are less prone to scattering by lattice defects or impurities, resulting in high mobility. Such 2DEG characteristics enable the HEMT 100 to operate at higher frequencies and improve switching speeds.

Based on the aforementioned characteristics, the HEMT 100 is known to have low noise and high energy efficiency. Furthermore, the HEMT 100 has relatively low on-resistance and thus can enhance the efficiency of devices using power. Furthermore, the HEMT 100 can withstand high power densities due to the 2DEG formed by a strong electric field.

The HEMT 100 may be formed based on gallium nitride (GaN).

GaN HEMTs are high-performance electronic devices, particularly suitable for high-power, high-frequency applications. GaN HEMTs are known to have superior electrical characteristics compared to traditional silicon-based transistors, which is due to the physical and electrical properties of the GaN material. Hereinafter, an embodiment based on an example in which a GaN HEMT 100 is adopted as a HEMT will be described.

The barrier layer 102 may be formed of AlGaN. In addition, the channel layer 132 may be formed of GaN.

The GaN HEMT 100 may include a two-dimensional electron gas (2DEG). The GaN HEMT 100 may have the 2DEG formed at the interface between the barrier layer 102 and the channel layer 132 in an AlGaN/GaN structure. This 2DEG creates a channel through which electrons can move with very high mobility.

GaN has a very high breakdown voltage (BV). Furthermore, GaN has high thermal conductivity. Accordingly, the GaN HEMT 100 can operate stably even at high voltages and effectively dissipate heat, and thus can be suitably used in high-power applications.

The GaN HEMT 100 can have a high electron channel density due to the large number of electrons provided through the barrier layer 102, thereby achieving low on-resistance Ron and high current capacity. Furthermore, the GaN HEMT 100 can have a very high switching speed due to the high electron mobility of GaN and the channel characteristics of the 2DEG.

The GaN material itself is known to have a breakdown voltage (BV) approximately 10 times higher than that of silicon, and the high thermal conductivity thereof is advantageous for heat management. Furthermore, GaN has high electron mobility, making it highly suitable for high-frequency applications, and its wide bandgap allows for stable electrical characteristics even at high temperatures.

The GaN HEMT 100 may further include the substrate layer 162. The substrate layer 162 may be formed of a single crystal substrate such as silicon carbide (SiC), Si, GaN, or aluminum nitride (AlN). In one embodiment, the substrate layer 162 may be formed of silicon (Si).

A buffer layer 152 may be disposed on the substrate layer 162. The buffer layer 152 may be formed of aluminum nitride (AlN).

An AlGaN layer 142 may be disposed on the buffer layer 152, and the channel layer 132 may be disposed on the AlGaN layer 142.

Furthermore, the barrier layer 102 may be disposed on the channel layer 132. The channel layer 132 formed of GaN and the barrier layer 102 formed of AlGaN are layers formed of different bandgap semiconductor materials, and thus a dense electron region (or channel) may be formed at the interface between the two layers.

The first drain terminal D1, the gate terminal GT, and the second drain terminal D2 may be arranged on the channel layer 132. The GaN HEMT 100 is of a horizontal type, and in the vertical direction, the channel layer 132 may be disposed under the first drain terminal D1, the gate terminal GT, and the second drain terminal D2. In addition, the first drain terminal D1, the gate terminal GT, and the second drain terminal D2 may be disposed in this order in the horizontal direction.

A p-GaN layer 112 may further be disposed between the gate terminal GT and the barrier layer 102 or between the gate terminal GT and the channel layer 132.

A ground plate 122 may be disposed between the gate terminal GT and the second drain terminal D2. In the horizontal direction, the ground plate 122 may be disposed between the gate terminal GT and the second drain terminal D2. Further, the ground plate 122 may not be in direct contact with the channel layer 132, and an insulating layer may be disposed therebetween. The barrier layer 102 may be disposed between the insulating layer and the channel layer 132.

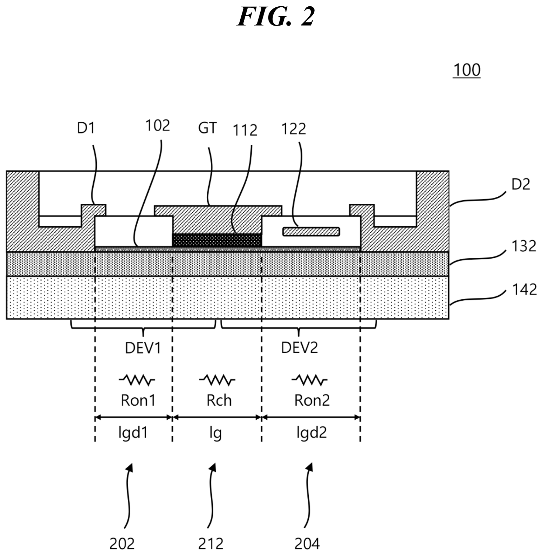

FIG. 2 is a cross-sectional view of the GaN HEMT according to an embodiment, in which the terminals and the channel layer are shown in an enlarged view.

Referring to FIG. 2, a first drift area 202, a second drift area 204, and a channel area 212 may be formed in the channel layer 132.

The first drift area 202 may be formed between the first drain terminal D1 and the gate terminal GT in the channel layer 132. Furthermore, the second drift area 204 may be formed between the second drain terminal D2 and the gate terminal GT in the channel layer 132. Further, the channel area 212 may be formed at a location corresponding to the gate terminal GT in the channel layer 132, for example, at a location below the gate terminal GT. When the p-GaN layer 112 is disposed under the gate terminal GT, the p-GaN layer 112 may be disposed on the channel area 212.

When the GaN HEMT 100 is turned on, the resistance Ron for the current flowing from the first drain terminal D1 to the second drain terminal D2 may have a resistance value equal to a series combination of the first drift resistance Ron1 formed in the first drift area 202, the channel resistance Rch formed in the channel region 212, and the second drift resistance Ron2 formed in the second drift area 204. Ron = Ron1 + Rch + Ron2

The magnitude of the first drift resistance Ron1 may be proportional to the length lgd1 of the first drift area 202. The length lgd1 of the first drift area 202 can be measured as the minimum distance between an edge of the first drain terminal D1 in contact with the upper surface of the channel layer 132 and an edge of the gate terminal GT. The shorter the length lgd1 of the first drift area 202, the smaller the magnitude of the first drift resistance Ron1.

The magnitude size of the second drift resistance Ron2 may be proportional to the length lgd2 of the second drift area 204. The length lgd2 of the second drift area 204 may be measured as the minimum distance between an edge of the second drain terminal D2 in contact with the upper surface of the channel layer 132 and an edge of the gate terminal GT. The shorter the length lgd2 of the second drift area 204, the smaller the magnitude of the second drift resistance Ron2.

Functionally, the GaN HEMT 100 may be composed of two elements DEV1 and DEV2.

The first element DEV1 may be composed of the first drain terminal D1, the gate terminal GT, and an area from the first drain terminal D1 to the gate terminal GT in the channel layer 132.

The second element DEV2 may be composed of the second drain terminal D2, the gate terminal GT, and an area from the second drain terminal D2 to the gate terminal GT in the channel layer 132.

In addition, the first element DEV1 may operate as a voltage blocking element, and the second element DEV2 may operate as a switching element. On/off of the GaN HEMT 100 can be determined according to the operation of the second element DEV2, and the breakdown voltage characteristics of the GaN HEMT 100 can be determined by the first element DEV1 in the turned-off state.

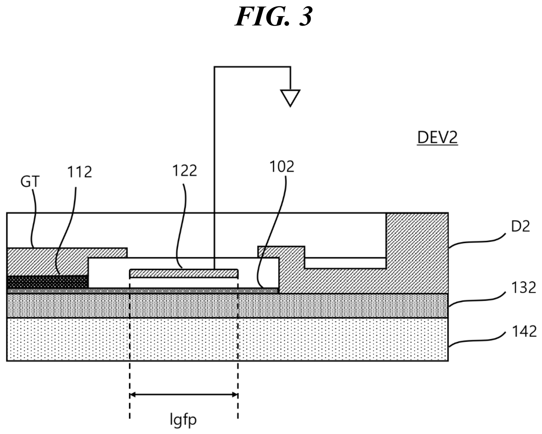

FIG. 3 is a diagram showing the configuration of a switching element according to an embodiment.

Referring to FIG. 3, the second element DEV2 (switching element) included in the GaN HEMT may include the second drain terminal D2, the gate terminal GT, the ground plate 122, the barrier layer 102, the channel layer 132, etc.

On/off of the GaN HEMT can be determined depending on the magnitude of the voltage (hereinafter referred to as a gate voltage) formed between the gate terminal GT and the second drain terminal D2 in the second element DEV2. For example, the GaN HEMT can be turned on when the gate voltage is higher than a threshold voltage. The GaN HEMT can be turned off when the gate voltage is lower than the threshold voltage.

If the gate voltage is higher than the threshold voltage, a channel is formed in the channel area of the GaN HEMT, and electrons can move from the second drain terminal D2 to the first drain terminal. At this time, the electrons can have a very high energy state. This state is also called a "hot" state. If these high-energy electrons collide with the lattice inside the GaN HEMT, various negative effects can occur. For example, the threshold voltage can change, the device can deteriorate, and leakage current can flow through the insulator of the gate terminal GT. The phenomenon that causes these negative effects is called hot carrier injection (HCI).

The ground plate 122 can alleviate this HCI. The ground plate 122 can be connected to the ground. The ground plate 122 can reduce the peak electric field. This can alleviate the aforementioned HCI.

A parasitic capacitance called feedback capacitance may be formed between the gate terminal GT and the second drain terminal D2. This capacitance may degrade the voltage gain and/or frequency response of the second element DEV2. The ground plate 122 also has the effect of mitigating this feedback capacitance.

The ground plate 122 also has the effect of reducing the second drift resistance, in addition to the aforementioned HCI mitigation effect and feedback capacitance mitigation effect. However, as the length of the ground plate 122 increases, the length of the second drift area also increases, which may increase the magnitude of the second drift resistance.

In order to reduce the magnitude of the second drift resistance, the designer may determine the length lgft of the ground plate 122 in the direction from the second drain terminal D2 to the gate terminal GT as a minimum length of a predetermined design rule (DR).

The design rule (DR) may predetermine the smallest width or length that can be manufactured in the processes for producing the second element DEV2. The minimum sizes of lines, gates, holes, etc. may be defined according to this design rule (DR). The length lgft of the ground plate 122 in the direction from the second drain terminal D2 to the gate terminal GT may be determined as the minimum length of the predetermined design rule (DR), thereby minimizing the increase in the second drift resistance due to the length of the ground plate 122.

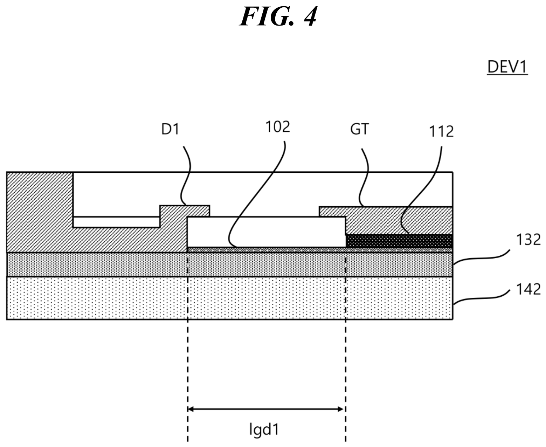

FIG. 4 is a diagram illustrating the configuration of a voltage blocking element according to an embodiment.

Referring to FIG. 4, the first element DEV1 (voltage blocking element) included in the GaN HEMT may include the first drain terminal D1, the gate terminal GT, the barrier layer 102, the channel layer 132, etc.

Unlike the second element, the first element DEV1 may not include the ground plate. The ground plate may be disposed between the gate terminal and the second drain terminal, and may not be disposed between the gate terminal GT and the first drain terminal D1.

To reduce the first drift resistance, the length lgd1 of the first drift area may be designed to be short.

The length lgd1 between the first drain terminal D1 and the gate terminal GT based on the upper surface of the channel layer 132 may be equal to a minimum allowable length of a predetermined photolithography process. By minimizing the first drift area length lgd1, the first drift resistance can be reduced.

However, if the first drift area length lgd1 is reduced, the breakdown voltage BV may decrease. The breakdown voltage BV may increase depending on the length of the drift area, and as described above, reducing the first drift area length lgd1 may have lower the breakdown voltage BV.

To compensate for this effect, a negative bias may be applied as the gate voltage in an embodiment.

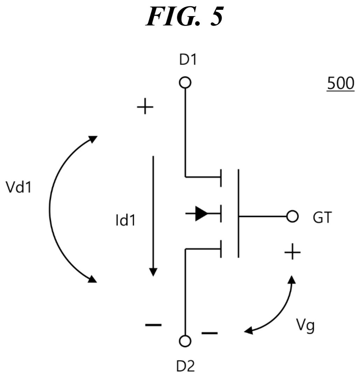

FIG. 5 is a circuit model of a GaN HEMT according to an embodiment.

Referring to FIG. 5, a gate voltage Vg may be formed between a gate terminal GT and a second drain terminal D2. When this gate voltage Vg exceeds a threshold voltage, a channel is formed in the GaN HEMT, and current Id1 may flow from a first drain terminal D1 to the second drain terminal D2 through the channel.

When the gate voltage Vg falls below the threshold voltage, the channel of the GaN HEMT closes, preventing current from flowing between the first drain terminal D1 and the second drain terminal D2, and a blocking voltage Vd1 may be generated.

In order to increase the limit (breakdown voltage BV) of the blocking voltage Vd1 that the GaN HEMT can withstand according to the embodiment, a voltage lower than the voltage of the second drain terminal D2 can be supplied to the gate terminal GT when the GaN HEMT is turned off. This causes the gate voltage Vg to become negative, and this state can be referred to as a negative bias.

When a negative bias is applied as the gate voltage Vg, the breakdown voltage BV of the GaN HEMT can increase.

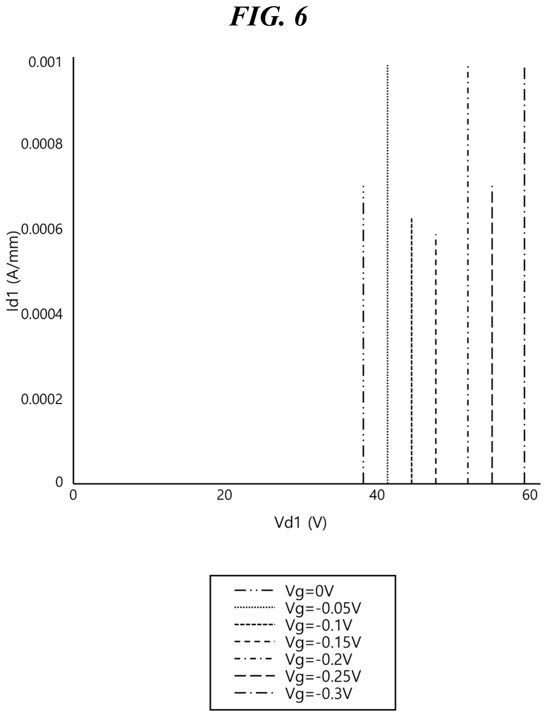

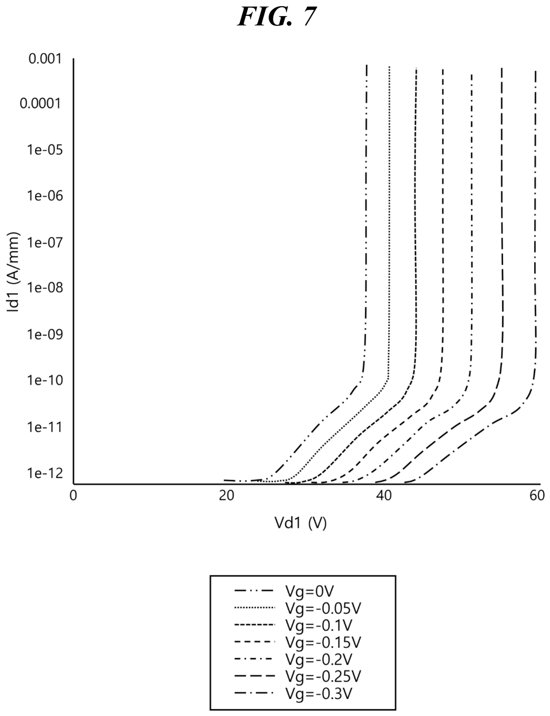

FIG. 6 is a graph showing the breakdown voltage of the GaN HEMT according to the gate voltage on a linear scale, and FIG. 7 is a graph showing the breakdown voltage of the GaN HEMT according to the gate voltage on a logarithmic scale.

Referring to FIG. 6 and FIG. 7, it can be ascertained that as the absolute value of the gate voltage as a negative voltage increases, the limit value of the blocking voltage Vd1 of the GaN HEMT increases.

In this way, it is possible to increase the magnitude of the breakdown voltage BV by applying a negative bias as the gate voltage, thereby reducing the length of the drift area and lowering the on-resistance Ron according to the embodiment.

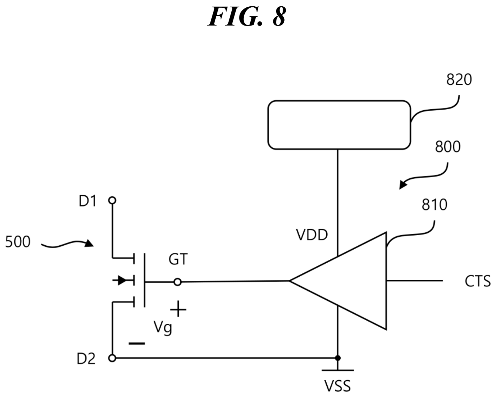

FIG. 8 is a diagram illustrating a configuration of a GaN HEMT driving device according to an embodiment.

Referring to FIG. 8, the driving device 800 can drive a GaN HEMT 500 including a channel layer in which a first drift area is formed between a first drain terminal D1 and a gate terminal GT, a channel area is formed at a location corresponding to the gate terminal GT, and a second drift area is formed between a second drain terminal D2 and the gate terminal GT.

The driving device 800 may include a gate driver 810 and a negative bias generator 820.

The gate driver 810 may include a VDD terminal, a VSS terminal, a signal input terminal, and a gate connection terminal.

A control signal CTS for instructing the GaN HEMT 500 to be turned off may be supplied to the signal input terminal of the gate driver 810. The gate driver 810 may supply a gate voltage Vg capable of turning off the GaN HEMT 500 to the GaN HEMT 500 according to the control signal CTS.

The VSS terminal of the gate driver 810 may be connected to the second drain terminal D2 of the GaN HEMT 500. Through this connection, a VSS voltage of the gate driver 810 and a second drain voltage of the GaN HEMT 500 may have a common voltage level.

A negative bias voltage output from the negative bias generator 820 may be supplied to the VDD terminal of the gate driver 810. In addition, the gate driver 810 can amplify the voltage formed between the VDD terminal and the VSS terminal and supply the same as the gate voltage Vg.

According to the above-described embodiments, complex device manufacturing processes, including new layout design and possible process step adjustments, may no longer be required. This can result in significant time and manufacturing cost savings.

According to the above-described embodiments, when a negative bias is applied as the gate voltage to achieve a higher breakdown voltage BV, the on-resistance Ron may remain unchanged. This may mean that the on-resistance Ron is lower than that of devices with the same rated voltage.

A lower on-resistance Ron may contribute to the efficiency of the overall system. Therefore, according to one embodiment, the system may reduce power consumption and adopt a simpler circuit design, thereby saving system-level resources.

The length of the path that forms the on-resistance Ron may account for a significant portion of the overall device pitch. In one embodiment, by adopting the shortest possible resistance path length, the Gross Die per Wafer (GDW) can be significantly increased and die cost can be reduced.

Terms such as "include", "comprise", and "have" described above imply that the corresponding component may be included unless specifically stated otherwise. Therefore, they should be interpreted as including other components rather than excluding them. All terms, including technical or scientific terms, have the same meanings as commonly understood by those of ordinary skill in the art to which the present disclosure pertains, unless otherwise defined. Commonly used terms, such as terms defined in dictionaries, should be interpreted as consistent with their meanings in the context of the relevant technology and, unless explicitly defined herein, should not be construed in an idealized or overly formal sense.

The above description merely exemplifies the technical concept of the present disclosure, and those of ordinary skill in the art will appreciate that various modifications and variations can be made without departing from the essential characteristics of the present disclosure. Therefore, the embodiments disclosed in the present disclosure are intended to illustrate, not limit, the technical concept of the present disclosure, and the scope of the technical concept of the present disclosure is not limited by these embodiments. The scope of protection of the present disclosure should be interpreted by the claims below, and all technical ideas within the scope equivalent thereto should be interpreted as being included in the scope of the rights of the present disclosure.

## Claims

1. A high electron mobility transistor (HEMT) comprising:
a first drain terminal;
a gate terminal;
a second drain terminal;
a channel layer in which a first drift area is formed between the first drain terminal and the gate terminal, a channel area is formed at a location corresponding to the gate terminal, and a second drift area is formed between the second drain terminal and the gate terminal; and
a ground plate disposed between the gate terminal and the second drain terminal.

2. The HEMT of claim 1, wherein the first drain terminal, the gate terminal, and a region corresponding to a position from the first drain terminal to the gate terminal in the channel layer form a first element, and the second drain terminal, the gate terminal, and a region corresponding to a position from the second drain terminal to the gate terminal in the channel layer form a second element,
wherein the first element operates as a voltage blocking element, and the second element operates as a switching element.

3. The HEMT of claim 1, wherein a length of the ground plate in a direction from the second drain terminal to the gate terminal is a minimum length of a predetermined design rule (DR).

4. The HEMT of claim 1, wherein the HEMT is of a horizontal type, the channel layer is disposed below the first drain terminal, the gate terminal, and the second drain terminal in a vertical direction, the first drain terminal, the gate terminal, and the second drain terminal are disposed in that order in a horizontal direction, and the ground plate is disposed between the gate terminal and the second drain terminal in the horizontal direction.

5. The HEMT of claim 4, wherein a portion of the second drift area is formed below the ground plate.

6. The HEMT of claim 4, wherein an insulating layer is disposed between the ground plate and the channel layer.

7. The HEMT of claim 1, wherein at least one of a buffer layer and a substrate layer is disposed under the channel layer.

8. The HEMT of claim 1, wherein the ground plate is disposed between the gate terminal and the second drain terminal and is not disposed between the gate terminal and the first drain terminal.

9. The HEMT of claim 1, wherein a length between the first drain terminal and the gate terminal on the upper surface of the channel layer is equal to a minimum allowable length of a predetermined photolithography process.

10. The HEMT of claim 1, wherein the channel layer includes a 2DEG formed at an interface of adjacent AlGaN/GaN structures.

11. A device for driving a HEMT comprising a channel layer in which a first drift area is formed between a first drain terminal and a gate terminal, a channel area is formed at a location corresponding to the gate terminal, and a second drift area is formed between a second drain terminal and the gate terminal,
the device comprising a gate driver configured to supply a voltage lower than a voltage of the second drain terminal to the gate terminal when turning off the HEMT.

12. The device of claim 11, wherein the first drain terminal, the gate terminal, and a region corresponding to a position from the first drain terminal to the gate terminal in the channel layer form a first element, and the second drain terminal, the gate terminal, and a region corresponding to a position from the second drain terminal to the gate terminal in the channel layer form a second element,
wherein the first element operates as a voltage blocking element, and the second element operates as a switching element.

13. The device of claim 11, wherein the HEMT further comprises a ground plate disposed between the gate terminal and the second drain terminal.

14. The device of claim 13, wherein a length between the first drain terminal and the gate terminal on the upper surface of the channel layer is equal to a predetermined minimum allowable length of a photolithography process.

15. The device of claim 13, wherein a length of the ground plate is a minimum length of a predetermined design rule (DR) in a direction from the second drain terminal to the gate terminal.

16. A high electron mobility transistor (HEMT) comprising:
a first drain terminal;
a gate terminal;
a second drain terminal; and
a channel layer in which a first drift area is formed between the first drain terminal and the gate terminal, a channel area is formed at a location corresponding to the gate terminal, and a second drift area is formed between the second drain terminal and the gate terminal,
wherein a negative bias is applied as a gate voltage between the gate terminal and the second drain terminal when the HEMT is turned off.

17. The HEMT of claim 16, further comprising a ground plate disposed between the gate terminal and the second drain terminal.

18. The HEMT of claim 17, wherein a length of the ground plate is a minimum length of a predetermined design rule (DR) in a direction from the second drain terminal to the gate terminal.

19. The HEMT of claim 16, wherein the HEMT is an enhancement-mode (E-mode) HEMT exhibiting a normally-off state.

20. The HEMT of claim 16, wherein a length between the first drain terminal and the gate terminal on the upper surface of the channel layer is equal to a minimum allowable length of a predetermined photolithography process.
